(19) Europäisches Patentamt
European Patent Office
Office européen des brevets

(11) **EP 4 138 258 B1**

(12) **EUROPÄISCHE PATENTSCHRIFT**

(45) Veröffentlichungstag und Bekanntmachung des Hinweises auf die Patenterteilung:
**15.05.2024   Patentblatt 2024/20**

(21) Anmeldenummer: **22181503.8**

(22) Anmeldetag: **28.06.2022**

(51) Internationale Patentklassifikation (IPC):
***H02J 7/00*** *(2006.01)*

(52) Gemeinsame Patentklassifikation (CPC):
**H02J 7/00714; H02J 7/007192;** Y02E 60/10

(54) **VERFAHREN ZUR STEUERUNG EINES LADESTROMGRENZWERTS FÜR EIN BATTERIEMANAGEMENTSYSTEM, BATTERIEMANAGEMENTSYSTEM**

BATTERY MANAGEMENT SYSTEM AND METHOD FOR CONTROLLING A CHARGING CURRENT THRESHOLD FOR A BATTERY MANAGEMENT SYSTEM

PROCÉDÉ DE COMMANDE D'UNE VALEUR LIMITE DE COURANT DE CHARGE POUR UN SYSTÈME DE GESTION DE BATTERIE, SYSTÈME DE GESTION DE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.08.2021   DE 102021208939**

(43) Veröffentlichungstag der Anmeldung:
**22.02.2023   Patentblatt 2023/08**

(73) Patentinhaber: **Robert Bosch GmbH**
**70442 Stuttgart (DE)**

(72) Erfinder:
• **Scharff, Vincent**
**70439 Stuttgart (DE)**
• **Zafiridis, Triantafyllos**
**74074 Heilbronn (DE)**
• **Becker, Jens**
**71726 Benningen Am Neckar (DE)**
• **Watterott, Melwin Pascal**
**73266 Bissingen An Der Teck (DE)**
• **Aleksandrov, Aleksandar**
**70372 Stuttgart (DE)**
• **Cois, Olivier**
**71394 Kernen (DE)**
• **Kroener, Christoph**
**71691 Freiberg Am Neckar (DE)**

(56) Entgegenhaltungen:
US-A1- 2020 136 173     US-A1- 2020 212 684
US-B2- 9 035 621     US-B2- 9 413 189

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Steuerung eines Ladestromgrenzwerts für ein Batteriemanagementsystem.

Die Erfindung betrifft ferner ein Batteriemanagementsystem, das dazu eingerichtet ist, das erfindungsgemäße Verfahren durchzuführen.

Die Erfindung betrifft auch eine Batterie mit einer oder mehreren Batteriezellen, die dazu eingerichtet ist, das erfindungsgemäße Verfahren durchzuführen, und/oder die das erfindungsgemäße Batteriemanagementsystem umfasst.

Die Erfindung betrifft weiterhin ein Fahrzeug, das dazu eingerichtet ist, das erfindungsgemäße Verfahren durchzuführen, und/oder das das erfindungsgemäße Batteriemanagementsystem und/oder die erfindungsgemäße Batterie umfasst.

Stand der Technik

Es zeichnet sich ab, dass in Zukunft vermehrt elektrisch angetriebene Kraftfahrzeuge zum Einsatz kommen werden. In solchen elektrisch angetriebenen Kraftfahrzeugen, wie z. B. Hybridfahrzeugen und Elektrofahrzeugen, werden aufladbare Batterien eingesetzt, vorwiegend um elektrische Antriebseinrichtungen mit elektrischer Energie zu versorgen.

Als ein elektrochemisches System kann eine Batteriezelle nur eine bestimmte Menge an Ladung während des Ladevorgangs aufnehmen. Unter bestimmten Bedingungen können unerwünschte Nebenreaktionen auftreten, wie beispielsweise Lithium-Plating. Während des Ladevorgangs wird Lithium in die Anode eingebracht. Wenn aber der Ladestrom zu hoch ist, wird Lithiummetall auf der Anodenoberfläche abgeschieden, anstatt interkaliert zu werden. Bedingungen, die zum Lithium-Plating führen könnten, sind beispielsweise hoher Ladestrom, Lange Ladezeit ohne Pause, niedrige Temperatur und hoher Ladezustand SOC (State Of Charge). Lithium-Plating kann zu einem hohen Kapazitätsverlust, einer starken Widerstandserhöhung und einer starken Reduzierung der Leistung der Batteriezelle. Letztendlich hat dieser Effekt einen direkten Einfluss auf die verfügbare Leistung und kann die Lebensdauer der Batteriezelle verkürzen.

US 9035621 B2 zeigt das adaptive Laden von Batterien, insbesondere von Lithium-Ionen Batterien. Dabei werden Ladungspakete berechnet, deren Höhe und Weite, und eine Relaxationszeit zwischen Ladungspulsen, so dass es nicht zu Über- oder Unterschwingern kommt und die Relaxationszeit zu den Pulsen passt.

Ziel der vorliegenden Erfindung ist, einen maximal zulässigen Strom in Laderichtung zu berechnen, ohne Lithium-Plating zu verursachen.

Offenbarung der Erfindung

Es wird ein Verfahren zur Steuerung eines Ladestromgrenzwerts für ein Batteriemanagementsystem vorgeschlagen. Das Batteriemanagementsystem ist dabei zur Überwachung und Steuerung einer Batterie eingerichtet. Die Batterie kann dabei eine oder mehrere seriell oder parallel verschaltete Batteriezellen umfasst. Die Batteriezelle ist dabei als Lithium-Ionen-Zelle ausgebildet. Erfindungsgemäß werden zunächst für eine gemessene Temperatur $T_{sens}$ und einen gegebenen Ladezustand SOC Referenzströme $i_{ref}$ für unterschiedlichen Dauern $t_{ref}$ bestimmt. Dabei stellt der Referenzstrom $i_{ref}$ den maximal erlaubte Ladestrom bei dieser gemessenen Temperatur $T_{sens}$ und diesem gegebenen Ladezustand SOC für die entsprechende Dauer $t_{ref}$ dar. Beispielsweise werden für eine gemessene Temperatur $T_{sens}$ von 25 °C und einen gegebenen Ladezustand SOC die Referenzströme $i_{ref2s}$, $i_{ref10s}$ und $i_{ref30s}$ für die entsprechenden Dauern $t_{ref}$ von 2 s, 10 s und 30 s bestimmt. Wenn die im Zellendatenblatt definierten Temperaturen beispielsweise von 20 °C und 30 °C sind, können diese Referenzströme interpoliert werden, wenn dies vom Zellendatenblatt erlaubt ist.

Anschließend wird für jeden Referenzstrom $i_{ref}$ eine entsprechende Referenzzeitkonstante $\tau_{ref}$ anhand eines Modells zur Berechnung eines Durchschnittswerts $i_{avrg}$ eines Ladestroms $i_{req}$ mithilfe eines Dauerstroms $i_{cont}$ berechnet, der dem minimalen Strom, der ohne Lithium-Plating zulässig ist, entspricht. Die Hauptaufgabe des Modells besteht darin, einen bestimmten Strom für die angegebene Dauer aus der Zellendatenblatt zuzulassen. Durch dieses Modell wird somit das dynamische Verhalten von Grenzwerten des Stroms modelliert. Beispielsweise, wenn aus dem Zellendatenblatt hervorgeht, dass ein Strom von 150 A nur 2 s dauern darf, muss dieser Strom dann für 2 s oder weniger zugelassen werden. Dazu wird die Referenzzeitkonstante $\tau_{ref}$ derart angepasst, dass der Grenzwert des Stroms bei 2 s oder früher eintritt. Beispielsweise wird für die jeweiligen Referenzströme $i_{ref2s}$, $i_{ref10s}$ und $i_{ref30s}$ eine entsprechende Referenzzeitkonstante $\tau_{ref2s}$, $\tau_{ref10s}$ und $\tau_{ref30s}$ berechnet.

Anhand der berechneten Referenzzeitkonstanten $\tau_{ref}$ und der bestimmten Referenzströme $i_{ref}$ wird danach ein Diagramm über das Verhältnis zwischen der Referenzzeitkonstante $\tau_{ref}$ und dem Referenzstrom $i_{ref}$ für jede bestimmte Temperatur T und jeden bestimmten Ladezustand SOC gebildet.

Anschließend wird eine prädiktive Zeitkonstante $\tau_{pred}$ durch Vergleich eines Messwerts $i_{sens}$ eines Ladestroms $i_{req}$ mit den Referenzströmen $i_{ref}$ ermittelt. Wenn der Messwert $i_{sens}$ des Ladestroms $i_{req}$ gleich einem Referenzstrom $i_{ref}$ ist, ist der die prädiktive Zeitkonstante $\tau_{pred}$ gleich der diesem Referenzstrom $i_{ref}$ entsprechenden Referenzzeitkon-

stante $\tau_{ref}$. Andernfalls wird die prädiktive Zeitkonstante $\tau_{pred}$ durch Interpolation ermittelt.

Danach wird ein prädiktiver Grenz-Durchschnittswert $i_{pred}$ des Ladestroms $i_{req}$ basierend auf dem Dauerstrom $i_{cont}$, einer prädiktiven Dauer $t_{pred}$ und der prädiktive Zeitkonstante $\tau_{pred}$ berechnet. Die prädiktive Dauer $t_{pred}$ entspricht dabei den Zeiten, in denen ein Konstantstrom ohne Begrenzung durch ein Batteriemanagementsystem verwendet werden kann. Die prädiktive Dauer kann kundenspezifisch sein.

Der Referenzstrom $i_{ref}$ und die Dauer $t_{ref}$ des Referenzstroms $i_{ref}$ sind zellenspezifisch und temperatur- sowie ladezustandsabhängig. Diese können direkt aus dem Zellendatenblatt entnommen oder durch Messungen erhalten werden.

Vorzugsweise wird das Modell zur Berechnung des Durchschnittswerts $i_{avrg}$ eines Ladestroms $i_{req}$ als ein PT1-Glied ausgebildet, das auch als PT1-Filter bezeichnet wird. Unter ein PT1-Glied wird ein LZI (lineares zeitinvariantes System) - Übertragungsglied in der Regelungstechnik verstanden, welches ein proportionales Übertragungsverhalten mit Verzögerung 1. Ordnung aufweist. Ein gebräuchliches Beispiel ist ein Tiefpass 1. Ordnung, der beispielsweise durch ein RC-Glied realisiert werden kann. Vorteilhaft ist ein PT1-Glied einfach zu implementieren.

Mittels des bevorzugt als ein PT1-Glied ausgebildeten Modell wird das erfindungsgemäße Verfahren verdeutlicht. Dabei wird der Durchschnittswert $i_{avrg}$ eines Ladestroms $i_{req}$ gemäß einer ersten Gleichung wie folgt berechnet:

$$i_{avrg}(t) = \left(1 - e^{-\frac{t}{\tau}}\right) \cdot i_{sens}(t) + i_{avrg0} \cdot e^{-\frac{t}{\tau}} \qquad (1)$$

Dabei ist $i_{avrg}(t)$ der aktuelle Durchschnittswert des Ladestroms $i_{req}$ und zeitabhängig, $i_{avrg0}$ der anfängliche Durchschnittswert des Ladestroms $i_{req}$, t die Zeit, $\tau$ die Zeitkonstante des PT1-Glieds und $i_{sens}(t)$ der Messwert des Ladestroms $i_{req}$.

Der Durchschnittswert $i_{avrg}(t)$ des Ladestroms $i_{req}$ wird dann mittels einer zweiten Gleichung wie folgt mit einem Dauerstrom $i_{cont}$, der temperatur- und ladezustandsabhängig ist, verglichen:

$$i_{avrg}(t) \leq i_{cont}(T, SOC) \qquad (2)$$

Dieser Dauerstrom $i_{cont}$ entspricht dem minimalen Strom, der ohne Lithium-Plating zulässig ist, und kann aus dem Zellendatenblatt entnommen werden. Der Dauerstrom $i_{cont}$ ist zur Begrenzung des Ladestroms $i_{req}$ relevant und stellt sicher, dass kein Lithium-Plating der Batteriezelle entsteht.

Mit der Voraussetzung, dass $i_{avrg}(t)$ gleich $i_{cont}$ ist, kann ein prädiktiver Grenz-Durchschnittswert $i_{pred}$, welcher dem Messwert $i_{sens}$ des Ladestrom $i_{req}$ in der ersten Gleichung entspricht, mittels einer dritten Gleichung wie folgt berechnet werden:

$$i_{pred}(t) = \frac{i_{cont}(T, SOC) - i_{avrg0} \cdot e^{-\frac{t}{\tau}}}{1 - e^{-\frac{t}{\tau}}} \qquad (3)$$

Dabei ist T die Temperatur und SOC der Ladezustand der Batteriezelle.

Für eine bestimmte Temperatur T und eine bestimmte prädiktive Dauer $t_{pred}$ kann eine neue dritte Gleichung wie folgt hergeleitet werden:

$$i_{pred}(t_{pred}) = \frac{i_{cont} - i_{avrg0} \cdot e^{-\frac{t_{pred}}{\tau}}}{1 - e^{-\frac{t_{pred}}{\tau}}} \qquad (3')$$

Hierbei wird eine Konstante k eingeführt. Diese Konstante k ist wie folgend definiert:

$$k = e^{-\frac{t_{pred}}{\tau}}$$

Somit wird eine vereinfachte neue dritte Gleichung wie folgt von der neuen dritten Gleichung hergeleitet:

$$i_{pred}(t_{pred}) = \frac{i_{cont} - i_{avrg0} \cdot k}{1 - k} \qquad (3'')$$

Der anfängliche Durchschnittswert $i_{avrg0}$ kann mithilfe des Referenzstroms $i_{ref}$ und der Dauer $t_{ref}$ des Referenzstroms $i_{ref}$ durch eine Sprungantwort, die wie folgt in einer vierten Gleichung beschrieben ist, erhalten werden:

$$i_{avrg0}\big(t_{ref}\big) = \left(1 - e^{-\frac{t_{ref}}{\tau}}\right) \cdot i_{ref} \qquad (4)$$

Anhand von der vereinfachten neuen dritten Gleichung (3") und der vierten Gleichung wird der prädiktive Grenz-Durchschnittswert $i_{pred}$ für eine bestimmte prädiktive Dauer $t_{pred}$ mittels einer fünften Gleichung wie folgt berechnet:

$$i_{pred}\big(t_{pred}\big) = \frac{i_{cont} - \left(1 - e^{-\frac{t_{ref}}{\tau}}\right)\cdot i_{ref}\cdot k}{1-k} \qquad (5)$$

Mit der Voraussetzung, dass $i_{pred}(t_{pred})$ gleich $i_{ref}$ ist, wird die Zeitkonstante $\tau$ wie folgt mittels einer sechsten Gleichung hergeleitet:

$$\tau = \frac{-t_{ref}}{ln\left(\frac{i_{ref} - i_{cont}}{k \cdot i_{ref}}\right)} \qquad (6)$$

Somit wird eine Zeitkonstante $\tau$ für jeden bestimmten Referenzstrom $i_{ref}$ und die bestimmte Dauer $t_{ref}$ berechnet. Mittels der sechsten Gleichung kann für jede bestimmte Temperatur T und jeden bestimmten Ladezustand SOC eine neue Zeitkonstante $\tau$ berechnet werden, die sich gemäß dem Messwert $i_{sens}$ des Ladestrom $i_{req}$ anpasst.

Dabei wird der Messwert $i_{sens}$ des Ladestroms $i_{req}$ mit dem Referenzstrom $i_{ref}$ für eine bestimmte Temperatur T, einen bestimmten Ladezustand SOC und eine bestimmte Dauer $t_{ref}$ verglichen, um eine geeignete prädiktive Zeitkonstante $\tau_{pred}$ herzuleiten.

Wenn, beispielsweise, der Messwert $i_{sens}$ des Ladestroms $i_{req}$ gleich dem Referenzstrom $i_{ref2s}$ für eine Dauer $t_{ref}$ von 2 s ist, kann eine prädiktive Zeitkonstante $\tau_{pred}$ mittels der sechsten Gleichung berechnet werden. Dabei ist die prädiktive Zeitkonstante $\tau_{pred}$ gleich der Referenzzeitkonstante $\tau_{ref2s}$ für den Referenzstrom $i_{ref2s}$ für eine Dauer $t_{ref}$ von 2 s. Die Herabsetzung des Ladestroms $i_{req}$ beginnt dann nach 2 s.

Vorzugsweise wird das Ermitteln der prädiktiven Zeitkonstante $\tau_{pred}$ durch lineare Interpolation ausgeführt. Die prädiktive Zeitkonstante $\tau_{pred}$ ist somit dynamisch und passt sich gemäß dem Messwert $i_{sens}$ des Ladestrom $i_{req}$ an.

Wenn, beispielsweise, der Messwert $i_{sens}$ des Ladestroms $i_{req}$ größer als der Referenzstrom $i_{ref10s}$ für eine Dauer $t_{ref}$ von 10 s ist, aber kleiner als der Referenzstrom $i_{ref2s}$ für eine Dauer $t_{ref}$ von 2 s ist, kann eine prädiktive Zeitkonstante $\tau_{pred}$ durch eine lineare Interpolation zwischen der Referenzzeitkonstante $\tau_{ref2s}$ für den Referenzstrom $i_{ref2s}$ für eine Dauer $t_{ref}$ von 2 s, und der Referenzzeitkonstante $\tau_{ref10s}$ für den Referenzstrom $i_{ref10s}$ für eine Dauer $t_{ref}$ von 10 s, ermittelt werden.

Mittels der ermittelten prädiktiven Zeitkonstante $\tau_{pred}$ und der dritten Gleichung kann ein prädiktiver Grenz-Durchschnittswert $i_{pred}$ berechnet werden.

Vorzugsweise wird ein zusätzlicher Punkt [$i_{min}$; $\tau_{relax}$] in das Diagramm über das Verhältnis zwischen der Referenzzeitkonstante $\tau_{ref}$ und dem Referenzstrom $i_{ref}$ hinzugefügt. Dieser Punkt ist hinzugefügt, um eine Relaxationszeitkonstante $\tau_{relax}$ für die Batteriezelle in einem entspannten oder einem quasi entspannten Zustand zu definieren. Dabei stellt $i_{min}$ einen kleinen Strom dar, bei dem keine Belastung für die Zelle auftritt. Dieser kleine Strom $i_{min}$ kann ein kleiner Ladestrom oder Entladestrom sein. Mittels dieser Definition kann eine kleine Relaxationszeitkonstante $\tau_{relax}$ ausgewählt werden, um beispielsweise einen großen Rekuperationsstrom zu erlauben. Dieser neue Punkt kann dabei von der Temperatur T und dem Ladezustand SOC abhängig sein.

Vorzugsweise werden basierend auf dem Grenz-Durchschnittswert $i_{pred}$ ein erster prädiktiver Grenzwert $i_{predS}$ für eine kurze prädiktive Dauer $t_{predS}$, ein zweiter prädiktiver Grenzwert $i_{predL}$ für eine lange prädiktive Dauer $t_{predL}$ und ein dritter prädiktiver Grenzwert $i_{predP}$ für eine permanente prädiktive Dauer $t_{predP}$ berechnet. Beispielsweise kann eine Dauer von weniger als 2 s als eine kurze prädiktive Dauer $t_{predS}$ definiert werden. Beispielsweise kann eine lange prädiktive Dauer $t_{predL}$ gleich 2 s sein, währen eine permanente prädiktive Dauer $t_{predP}$ gleich 10 s sein kann. Diese prädiktiven Dauern können kundenspezifisch sein. In der Regel handelt es sich bei diesen prädiktiven Dauern um feste Werte. Die prädiktive Dauer $t_{pred}$ entspricht dabei den Zeiten, in denen ein Konstantstrom ohne Begrenzung durch ein Batteriemanagementsystem verwendet werden kann. Dieser Konstantstrom kann beispielsweise zur Berechnung des dritten prädiktiven Grenzwerts $i_{predP}$ verwendet werden.

$$k = e^{-\frac{t_{pred}}{\tau}}$$

Vorzugsweise wird die Konstante bei der Berechnung des ersten prädiktiven Grenzwerts $i_{predS}$ festgelegt. Durch Festlegen der Konstante k und Variieren der Zeitkonstante $\tau$, die auch als eine kurze prädiktive Zeitkonstante $\tau_{predS}$ bezeichnet wird, ist der erste prädiktive Grenzwert $i_{predS}$ auch dynamisch, da er sich gemäß der aktuellen thermischen Belastung sowie der Belastung für Lithium-Plating der Batteriezelle anpasst.

Bei der Berechnung des zweiten prädiktiven Grenzwerts $i_{predL}$ und eines dritten prädiktiven Grenzwerts $i_{predP}$ sind zwei Voraussetzungen zu erfüllen.

Zum einen ist:

$$k_S \geq k_L(T, SOC) \geq k_P(T, SOC)$$

Dabei ist $k_S$ die Konstante $k = e^{-\frac{t_{pred}}{\tau}}$ für den ersten prädiktiven Grenzwert $i_{predS}$, die ein Festwert ist, $k_L(T, SOC)$ die Konstante $k = e^{-\frac{t_{pred}}{\tau}}$ für den zweiten prädiktiven Grenzwert $i_{predL}$ und kp(T, SOC) die Konstante $k = e^{-\frac{t_{pred}}{\tau}}$ für den dritten prädiktiven Grenzwert $i_{predP}$. Die Konstanten $k_L(T, SOC)$ und $k_L(T, SOC)$ sind dabei temperatur- und ladezustandsabhängig.

Zum anderen ist, wenn das PT1-Glied Null ist, dass der prädiktive Grenzwert $i_{predL}$ für eine lange prädiktive Dauer $t_{predL}$ den Referenzstrom $i_{ref}$ für diese lange Dauer $t_{predL}$ und für die aktuelle Temperatur T der Batteriezelle repräsentieren soll. Unter "PT1-Glied ist Null" wird verstanden, dass der Durchschnittswert $I_{avrg}$ des Ladestroms $i_{req}$ gleich null ist. Dabei ist die Konstante $k_L(T, SOC)$ für den zweiten prädiktiven Grenzwert $i_{predL}$ wie folgt definiert:

$$k_L(T, SOC) = e^{-\frac{t_{predL}}{\tau_{predL}(T,SOC)}}$$

Unter Berücksichtigung der beiden Voraussetzungen sind die Konstante $k_L$ und eine lange prädiktive Zeitkonstante $\tau_{predL}$ (T, SOC) für den zweiten prädiktiven Grenzwert $i_{predL}$ mithilfe von einer siebten und einer achten Gleichung wie folgt berechnet:

$$k_L(T, SOC) = 1 - \frac{i_{cont}(T,SOC)}{i_{ref,predL}(T,SOC)} \qquad (7)$$

$$\tau_{predL}(T, SOC) = -\frac{t_{predL}}{ln(k_L(T,SOC))} \qquad (8)$$

Dabei ist $i_{cont}$(T, SOC) der Dauerstrom, der dem minimalen Strom entspricht, der ohne Lithium-Plating zulässig ist, und aus dem Zellendatenblatt entnommen werden kann. $i_{ref,predL}$ ist dabei der Referenzstrom $i_{ref}$ für diese lange prädiktive Dauer $t_{predL}$.

Der zweite prädiktive Grenzwert $i_{predL}$ ist dann mithilfe von einer neunten Gleichung, die auch aus der dritten Gleichung hergeleitet ist, wie folgt zu berechnen:

$$i_{predL}(t) = \frac{i_{cont}(T,SOC) - i_{avrg0} \cdot e^{-\frac{t_{predL}}{\tau_{predL}(T,SOC)}}}{1 - e^{-\frac{t_{predL}}{\tau_{predL}(T,SOC)}}} \qquad (9)$$

Die Berechnung des dritten prädiktiven Grenzwerts $i_{predP}$ folgt den gleichen Voraussetzungen für die Berechnung des zweiten prädiktiven Grenzwerts $i_{predL}$. Dabei gilt $k_L(T,SOC) \geq k_P(T,SOC)$. Somit kann der dritte prädiktive Grenzwert $i_{predP}$ wie folgt mithilfe von einer zehnten Gleichung berechnet werden:

$$i_{predP}(t) = \frac{i_{cont}(T,SOC) - i_{avrg0} \cdot e^{-\frac{t_{predP}}{\tau_{predP}(T,SOC)}}}{1 - e^{-\frac{t_{predL}}{\tau_{predP}(T,SOC)}}} \qquad (10)$$

Dabei ist $\tau_{predP}$ (T, SOC) die permanente prädiktive Zeitkonstante für den dritten prädiktiven Grenzwert $i_{predP}$.

Es wird ferner ein Batteriemanagementsystem vorgeschlagen, das dazu eingerichtet ist, das erfindungsgemäße Verfahren durchzuführen.

Es wird auch eine Batterie mit einer oder mehreren Batteriezellen vorgeschlagen, die dazu eingerichtet ist, das erfindungsgemäße Verfahren durchzuführen, und/oder die das erfindungsgemäße Batteriemanagementsystem umfasst.

Es wird weiterhin ein Fahrzeug vorgeschlagen, das dazu eingerichtet ist, das erfindungsgemäße Verfahren durchzuführen, und/oder das das erfindungsgemäße Batteriemanagementsystem und/oder die erfindungsgemäße Batterie umfasst.

Vorteile der Erfindung

Mit der vorliegenden Erfindung kann ein Algorithmus effizient in einem Batteriemanagementsystem implementiert, der den Strom aus der Zellenspezifikationen begrenzt und damit die volle Leistungsverfügbarkeit und den Schutz von Batteriezellen vor Lithium-Plating und Komponenten sichergestellt.

Dabei werden Daten von Batteriezellen direkt zur Berechnung einer Zeitkonstante verwendet. Mit dem erfindungsgemäßen Verfahren können dabei der prädiktive Grenz-Durchschnittswert des Ladestroms und die prädiktiven Grenzwerte des Ladestroms für unterschiedliche prädiktive Dauer berechnet werden. Diese Größen sind vorteilhaft zum einen zur Erkennung potentieller vorzeitiger Alterung der Batteriezellen und zum anderen zur Anpassung einer Leistungsstrategie und einer Fahrstrategie eines Fahrzeugs.

Mittels des erfindungsgemäßen Verfahrens werden darüber hinaus ein Stresslevel zur Quantifizierung der Zellennutzung und eine schnelle Kalibration ermöglicht.

Weiterhin kann der Durchschnittswert $i_{avrg}$ des Ladestroms $i_{req}$ mit dem erfindungsgemäßen Verfahren berechnet werden, der als Maß für die Batteriebelastung verwendet werden kann. Dieser Durchschnittswert $i_{avrg}$ des Ladestroms $i_{req}$ kann aufgezeichnet werden, um den Stresslevel der Zelle zu visualisieren.

Ferner ist die Implementierung des erfindungsgemäßen Verfahrens effizient, da nur wenige Arbeitsspeicher für die Prozessoren des Batteriemanagementsystems benötigt werden. Das erfindungsgemäße Verfahren berücksichtigt den Stress, den die Zelle erfahren hat, mit einem einzigen Integrator.

Außerdem ist die Funktion des Verfahrens flexibel. Dabei kann der Prädiktionshorizont bzw. prädiktive Dauer je nach Bedarf eines Kunden geändert werden.

Kurze Beschreibung der Zeichnungen

Ausführungsformen der Erfindung werden anhand der Zeichnungen und der nachfolgenden Beschreibung näher erläutert.

Es zeigen:

Figur 1        eine schematische Darstellung des erwarteten Verhaltens eines Ladestromgrenzwerts,

Figur 2        eine schematische Darstellung eines Diagramms zur Ermittlung einer prädiktiven Zeitkonstante $\tau_{pred}$,

Figur 3.1      eine schematische Darstellung eines zeitlichen Verlaufs eines Grenz-Durchschnittswerts $i_{pred}$,

Figur 3.2      eine schematische Darstellung eines zeitlichen Verlaufs eines Durchschnittswerts $i_{avrg}$ des Ladestroms $i_{req}$ entsprechend Figur 3.1,

Figur 3.3      eine schematische Darstellung eines zeitlichen Verlaufs der prädiktiven Zeitkonstante $\tau_{pred}$ entsprechend Figur 3.1,

Figur 4.1      eine schematische Darstellung eines zeitlichen Verlaufs eines Ladestroms $i_{req}$,

Figur 4.2      eine schematische Darstellung eines zeitlichen Verlaufs einer gemessenen Spannung $u_{sens}$ der Batteriezelle entsprechend Figur 4.1,

Figur 4.3     eine schematische Darstellung eines zeitlichen Verlaufs eines Ladestroms $i_{req}$ mit Begrenzung dessen Durchschnittswerts $i_{avrg}$ entsprechend Figur 4.1,

Figur 5.1     eine schematische Darstellung eines zeitlichen Verlaufs eines Ladestroms $i_{req}$ mit Begrenzung dessen Durchschnittswerts $i_{avrg}$ gemäß einem ersten Beispiel,

Figur 5.2     eine schematische Darstellung eines zeitlichen Verlaufs einer prädiktiven Zeitkonstante $\tau_{pred}$ entsprechend Figur 5.1,

Figur 5.3     eine schematische Darstellung eines zeitlichen Verlaufs eines Ladezustands SOC und eines zeitlichen Verlaufs einer gemessenen Temperatur $T_{sens}$ entsprechend Figur 5.1,

Figur 6.1     eine schematische Darstellung eines zeitlichen Verlaufs eines Ladestroms $i_{req}$ mit Begrenzung dessen Durchschnittswerts $i_{avrg}$ gemäß einem zweiten Beispiel,

Figur 6.2     eine schematische Darstellung eines zeitlichen Verlaufs einer prädiktiven Zeitkonstante $\tau_{pred}$ entsprechend Figur 6.1,

Figur 6.3     eine schematische Darstellung eines zeitlichen Verlaufs eines Ladezustands SOC und eines zeitlichen Verlaufs einer gemessenen Temperatur $T_{sens}$ entsprechend Figur 6.1 und

Figur 7     eines Ablaufs des erfindungsgemäßen Verfahrens.

Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

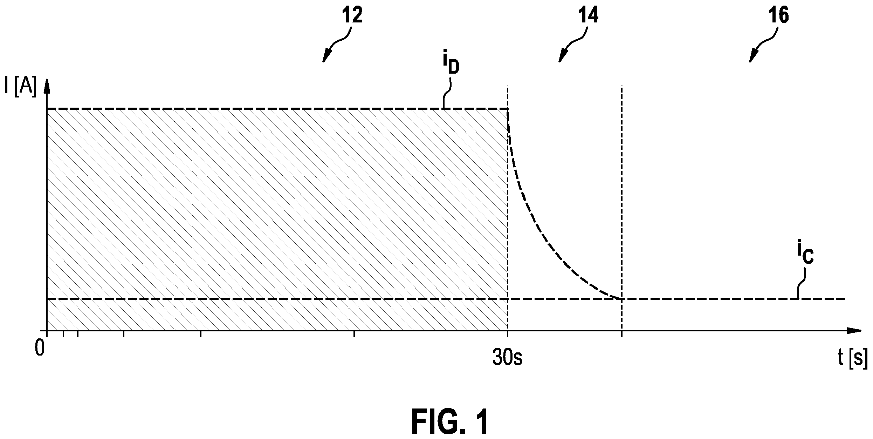

Figur 1 zeigt eine schematische Darstellung des erwarteten Verhaltens eines Ladestromgrenzwerts einer Batteriezelle. Die Erwartung ist, dass durch Verwendung von dynamischen Grenzwerten $i_D$ eines Batteriemanagementsystems zur Überwachung und Steuerung der Batteriezelle der anfängliche Wert eines Ladestroms $i_{req}$ in einer ersten Phase 12, welche beispielsweise 30 s dauert, nicht herabgesetzt wird und diese dynamischen Grenzwerte $i_D$ anschließend in einer zweiten Phase 14 zu kontinuierlichen Grenzwerten $i_C$ konvergieren. In einer dritten Phase 16 wird der Ladestrom $i_{req}$ dann durch die kontinuierlichen Grenzwerte $i_C$ begrenzt.

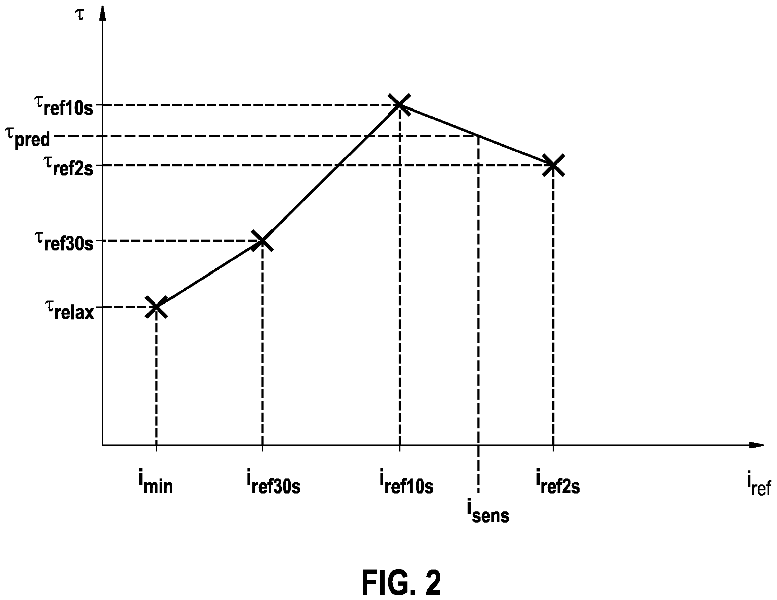

Figur 2 zeigt eine schematische Darstellung eines Diagramms zur Ermittlung einer prädiktiven Zeitkonstanten $\tau_{pred}$. Nachfolgend wird das Diagramm mithilfe eines Modells zur Berechnung eines Durchschnittswerts $i_{avrg}$ eines Ladestroms $i_{req}$ mit einem PT1-Glied erläutert.

Wie oben ausgeführt, wird eine Zeitkonstante $\tau$ für jeden bestimmten Referenzstrom $i_{ref}$ und eine bestimmte Dauer $t_{ref}$ sowie eine bestimmte Temperatur $T$ und einen bestimmten Ladezustand SOC berechnet. Vorliegend in Figur 2 werden für eine bestimmte Temperatur $T$ eine Referenzzeitkonstante $\tau_{ref30s}$ für einen Referenzstrom $i_{ref30s}$, der 30 s dauert, eine Referenzzeitkonstante $\tau_{ref10s}$ für einen Referenzstrom $i_{ref10s}$, der 10 s dauert, und eine Referenzzeitkonstante $\tau_{ref2s}$ für einen Referenzstrom $i_{ref2s}$, der 2 s dauert, berechnet.

Mittels dieser Daten wird ein Diagramm über das Verhältnis zwischen der Zeitkonstante $\tau$ und dem Referenzstrom $i_{ref}$ in Figur 2 gebildet.

Dabei wird der Messwert $i_{sens}$ des Ladestroms $i_{req}$ mit dem Referenzstrom $i_{ref}$ für eine bestimmte Dauer $t_{ref}$ verglichen, um eine geeignete prädiktive Zeitkonstante $\tau_{pred}$ herzuleiten.

Wenn beispielsweise der Messwert $i_{sens}$ des Ladestroms $i_{req}$ gleich dem Referenzstrom $i_{ref2s}$ ist, wird eine prädiktive Zeitkonstante $\tau_{pred}$ gleich der Referenzzeitkonstante $\tau_{ref2s}$, die für den Referenzstrom $i_{ref2s}$ berechnet wurde, berechnet. Die Herabsetzung des Ladestroms $i_{req}$ beginnt dann nach 2 s.

Wenn beispielsweise der Messwert $i_{sens}$ des Ladestroms $i_{req}$ größer als der Referenzstrom $i_{ref10s}$ ist, aber kleiner als der Referenzstrom $i_{ref2s}$ ist, wird eine prädiktive Zeitkonstante $\tau_{pred}$ durch eine lineare Interpolation zwischen der Referenzzeitkonstante $\tau_{ref10s}$ und der Referenzzeitkonstante $\tau_{ref2s}$ ermittelt.

Des Weiteren wird in das Diagramm gemäß Figur 2 ein zusätzlicher Punkt [$i_{min}$; $\tau_{relax}$] hinzugefügt. Dieser Punkt ist hinzugefügt, um eine Relaxationszeitkonstante $\tau_{relax}$ für die Batteriezelle in einem entspannten oder einem quasi entspannten Zustand zu definieren. Dabei stellt $i_{min}$ einen kleinen Strom dar. Mittels dieser Definition kann eine kleine Relaxationszeitkonstante $\tau_{relax}$ ausgewählt werden, um beispielsweise einen großen Rekuperationsstrom zu erlauben. Dieser neue Punkt kann dabei von der Temperatur $T$ und dem Ladezustand SOC abhängig sein.

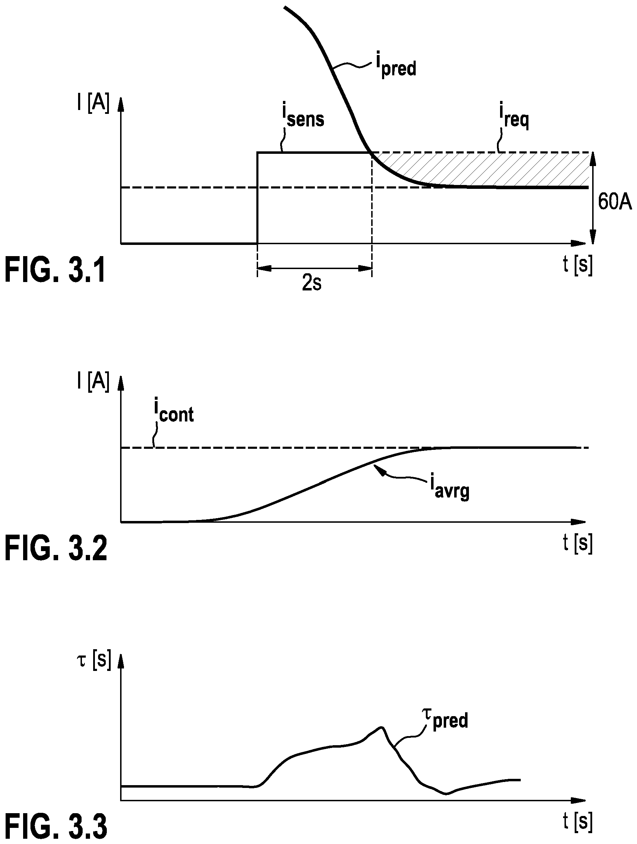

Figur 3.1 zeigt eine schematische Darstellung eines zeitlichen Verlaufs eines Grenz-Durchschnittswerts $i_{pred}$.

Dabei ist ein Messwert $i_{sens}$ des Ladestroms $i_{req}$ von 60 A erfasst. Ein Ladestrom $i_{req}$ von 60 A ist nur zulässig für eine Dauer von 2 s, ohne Lithium-Plating zu verursachen. Somit wird ein Grenz-Durchschnittswert $i_{pred}$ nach dem erfindungsgemäß vorgeschlagenen Verfahren berechnet. Die Herabsetzung des Ladestroms $i_{req}$ beginnt dann nach 2 s. Der Grenz-Durchschnittswert $i_{pred}$ konvergiert endlich zu einem Dauerstrom $i_{cont}$, der dem maximal zulässigen kontinuierlichen Ladestrom $i_{req}$ entspricht.

Figur 3.2 zeigt eine schematische Darstellung eines zeitlichen Verlaufs eines Durchschnittswert $i_{avrg}$ des Ladestroms $i_{req}$ entsprechend Figur 3.1, während Figur 3.3 eine schematische Darstellung eines zeitlichen Verlaufs einer prädiktive Zeitkonstante $\tau_{pred}$ entsprechend Figur 3.1 darstellt. Aus Figur 3.3 geht hervor, dass sich die prädiktive Zeitkonstante $\tau_{pred}$ gemäß dem Messwert $i_{sens}$ des Ladestroms $i_{req}$ anpasst.

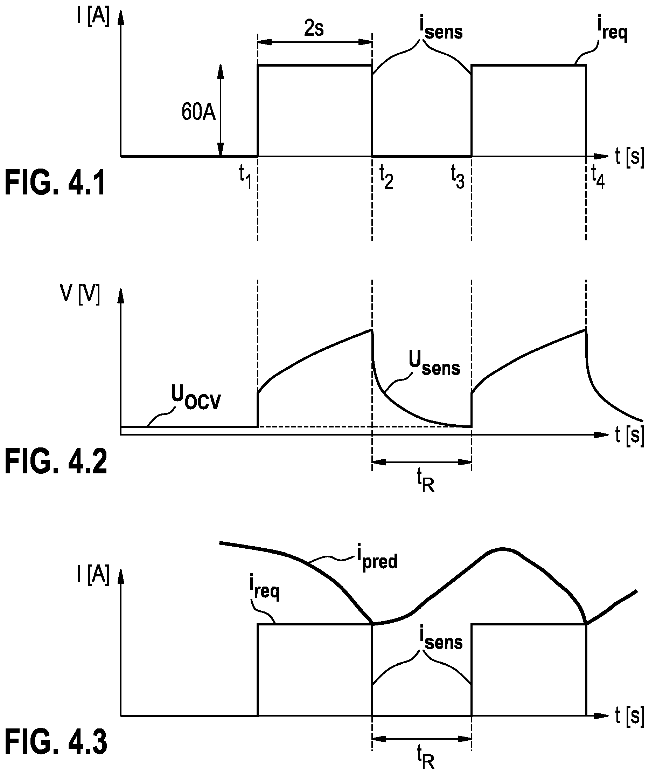

Figur 4.1 zeigt eine schematische Darstellung eines zeitlichen Verlaufs eines Ladestroms $i_{req}$. Der Ladestrom $i_{req}$ ist impulsförmig und weist zwei Stromimpulse mit gleichen Messwerten $i_{sens}$ von 60 A auf. Dabei beträgt die Dauer der jeweiligen Stromimpulse 2 s. Zum Zeitpunkt $t_1$ wird ein erster Stromimpuls gesendet und der erste Stromimpuls endet zum Zeitpunkt $t_2$. Zum Zeitpunkt $t_3$ wird ein zweiter Stromimpuls gesendet und der zweite Stromimpuls endet zum Zeitpunkt $t_4$.

Figur 4.2 zeigt eine schematische Darstellung eines zeitlichen Verlaufs einer gemessenen Spannung $u_{sens}$ der Batteriezelle entsprechend Figur 4.1. Die gemessene Spannung $u_{sens}$ der Batteriezelle weist am Anfang eine Leerlaufspannung $u_{OCV}$ auf. Durch Laden mit dem Ladestrom $i_{req}$ steigt die gemessene Spannung $u_{sens}$ der Batteriezelle an. Erst ab dem Zeitpunkt $t_2$ sinkt die gemessene Spannung $u_{sens}$ der Batteriezelle ab. In einer Zwischenzeit $t_{relax}$ zwischen dem ersten und dem zweiten Stromimpuls, nämlich zwischen dem Zeitpunkt $t_2$ und dem Zeitpunkt ts, sinkt die gemessenen Spannung $u_{sens}$ mit einer Geschwindigkeit wie z.B. 1mV/min auf der Leerlaufspannung uocv ab. Diese Zwischenzeit $t_{relax}$ wird auch als Relaxationszeit bezeichnet.

Figur 4.3 zeigt eine schematische Darstellung eines zeitlichen Verlaufs eines Ladestroms $i_{req}$ mit Begrenzung dessen Durchschnittswerts $i_{avrg}$. Dabei steigt der berechnete Grenz-Durchschnittswert $i_{pred}$ während der Zwischenzeit $t_{relax}$ bzw. der Relaxationszeit auch an, um den zweiten Stromimpuls zu erlauben. Es ist notwendig, dass sich eine Zelle in entspannt oder relaxiert, bevor ein weiterer Stromimpuls mit der maximal zulässigen Leistung gegeben wird. Eine ruhende Zelle bedeutet, dass die gemessene Spannung der Leerlaufspannung uocv entspricht. Aus diesem Grund ist es wichtig, eine ausreichend lange Relaxationszeit zu berücksichtigen, um den zweiten Stromimpuls zu ermöglichen. Diese Relaxationszeit entspricht der Zeit, die die gemessene Spannung benötigt, um die Leerlaufspannung der Zelle zu erreichen. Es ist dann möglich, die maximale Leistung einzustellen, ohne das Risiko eines Lithium-Platings. Dieser Parameter kann je nach Temperatur T, Ladezustand SOC und Stromstärke des zuvor verwendeten Impulses unterschiedlich sein.

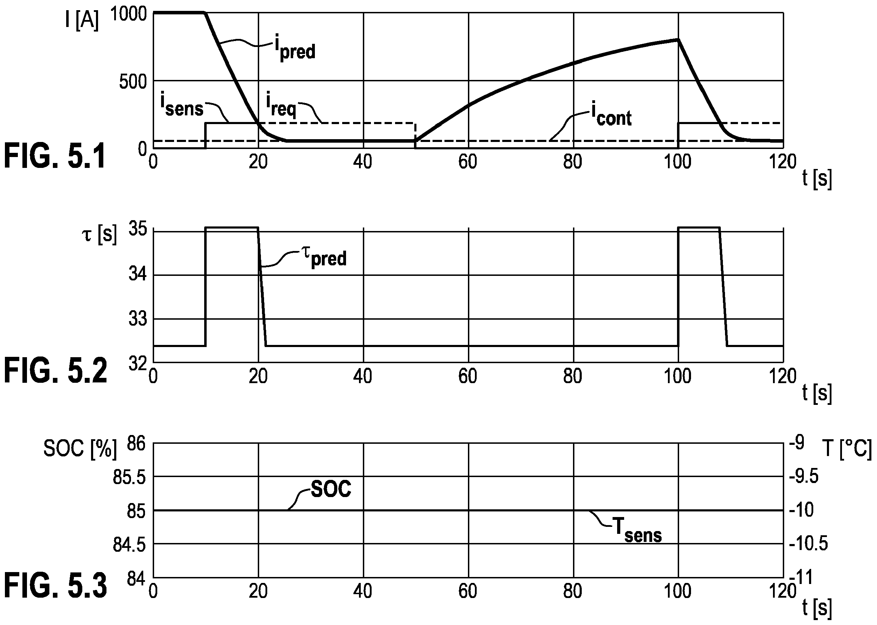

Figur 5.1 zeigt eine schematische Darstellung eines zeitlichen Verlaufs eines Ladestroms $i_{req}$ mit Begrenzung dessen Durchschnittswerts $i_{avrg}$ gemäß einem ersten Beispiel, während Figur 5.2 eine schematische Darstellung eines zeitlichen Verlaufs einer prädiktiven Zeitkonstante $\tau_{pred}$ entsprechend Figur 5.1 zeigt und Figur 5.3 eine schematische Darstellung eines zeitlichen Verlaufs eines Ladezustands SOC und eines zeitlichen Verlaufs einer gemessenen Temperatur $T_{sens}$ entsprechend Figur 5.1 zeigt.

Dabei werden die die zeitlichen Verläufe einer entspannten Batteriezelle mit einem anfänglichen Ladezustand SOC von 85% gezeigt. Eine anfängliche Temperatur T der Batteriezelle ist dabei -10 °C. Die Batteriezelle wird dabei mit einem Ladestrom $i_{req}$ von 175 A für eine Dauer von 30 s aufgeladen. Der Ladezustand SOC und die gemessene Temperatur $T_{sens}$ bleiben dabei unverändert.

Aus Figur 5.1 geht hervor, dass zum Zeitpunkt t = 10 s ein erster Stromimpuls, welcher den Ladestrom $i_{req}$ darstellt, mit einem Messwert $i_{sens}$ von 175 A an die Batteriezelle gesendet. Der erste Stromimpuls dauert 30 s. Dem Datenblatt der Batteriezelle ist zu entnehmen, dass ein Stromimpuls von 175 A bei einer Temperatur T von -10 °C und einem Ladezustand SOC von 85% nur für 10 s zulässig ist. Es werden dabei eine prädiktive Zeitkonstante $\tau_{pred}$ und ein Grenz-Durchschnittswert $i_{pred}$, welcher zu einem Dauerstrom $i_{cont}$ konvergiert, berechnet. Aus Figur 5.1 geht ferner hervor, dass zum Zeitpunkt t = 20 s, also nach 10 s vom Senden des ersten Stromimpulses, die Herabsetzung des ersten Stromimpulses beginnt. Der erste Stromimpuls wird auf dem Dauerstrom $i_{cont}$ herabgesetzt. Erst am Ende des ersten Stromimpulses fängt der Grenz-Durchschnittswert $i_{pred}$ an, wieder anzusteigen, um einen weiteren Stromimpuls zu erlauben. Zum Zeitpunkt t = 100 s wird ein zweiter Stromimpuls, der gleich dem ersten Stromimpuls ist, an die Batteriezelle gesendet. Aufgrund vom belasteten Zustand der Batteriezelle beginnt die Herabsetzung des zweiten Stromimpulses früher.

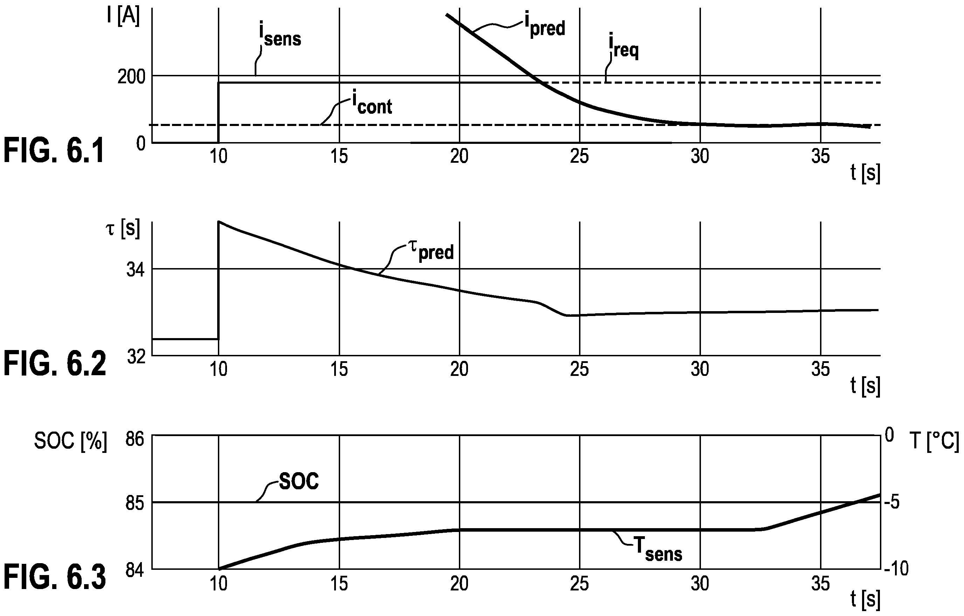

Figur 6.1 zeigt eine schematische Darstellung eines zeitlichen Verlaufs eines Ladestroms $i_{req}$ mit Begrenzung dessen Durchschnittswerts $i_{avrg}$ gemäß einem zweiten Beispiel, während Figur 6.2 eine schematische Darstellung eines zeitlichen Verlaufs einer prädiktiven Zeitkonstante $\tau_{pred}$ entsprechend Figur 6.1 zeigt und Figur 6.3 eine schematische Darstellung eines zeitlichen Verlaufs eines Ladezustands SOC und eines zeitlichen Verlaufs einer gemessenen Temperatur $T_{sens}$ entsprechend Figur 6.1 zeigt.

Dabei werden die die zeitlichen Verläufe einer entspannten Batteriezelle mit einem anfänglichen Ladezustand SOC von 85% gezeigt. Eine anfängliche Temperatur T der Batteriezelle ist dabei -10 °C. Die Batteriezelle wird dabei mit einem Ladestrom $i_{req}$ von 175 A für eine Dauer von 30 s aufgeladen. Der Ladezustand SOC bleibt dabei unverändert, während die gemessene Temperatur $T_{sens}$ während der Dauer des Stromimpulses ansteigt.

Aus Figur 6.1 geht hervor, dass zum Zeitpunkt t = 10 s ein Stromimpuls, welcher den Ladestrom $i_{req}$ darstellt, mit einem Messwert $i_{sens}$ von 175 A an die Batteriezelle gesendet. Der Stromimpuls dauert 30 s. Dem Datenblatt der Batteriezelle ist zu entnehmen, dass ein Stromimpuls von 175 A bei einer Temperatur T von -10 °C und einem Ladezustand SOC von 85% nur für 10 s zulässig ist. Es werden dabei eine prädiktive Zeitkonstante $\tau_{pred}$ und ein Grenz-Durchschnittswert $i_{pred}$, welcher zu einem Dauerstrom $i_{cont}$ konvergiert, berechnet. Da sich die gemessene Temperatur $T_{sens}$ der Batteriezelle während der Dauer des Stromimpulses ändert, wird die prädiktive Zeitkonstante $\tau_{pred}$ dynamisch berechnet. Aus Figur 6.1 geht ferner hervor, dass die Herabsetzung des Stromimpulses etwa später beginnt. Der Stromimpuls wird auf dem Dauerstrom $i_{cont}$ herabgesetzt. Dabei passt sich der Dauerstrom $i_{cont}$ auch gemäß der Temperatur T an.

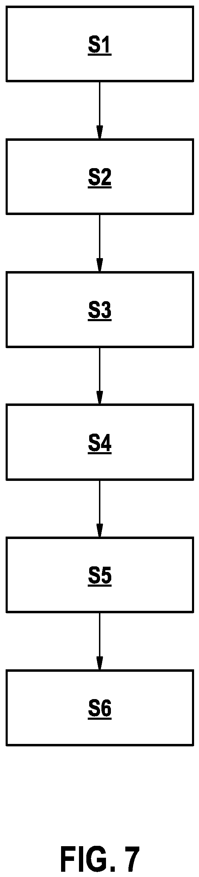

Figur 7 zeigt eines Ablaufs des erfindungsgemäßen Verfahrens. Dabei werden in einem Schritt S1 für eine gemessene Temperatur $T_{sens}$ und einen gegebenen Ladezustand SOC Referenzströme $i_{ref}$ für unterschiedlichen Dauern $t_{ref}$ bestimmt. Beispielsweise werden für eine gemessene Temperatur $T_{sens}$ von 25 °C und einen gegebenen Ladezustand SOC die Referenzströme $i_{ref2s}$, $i_{ref10s}$ und $i_{ref30s}$ für die entsprechenden Dauern $t_{ref}$ von 2 s, 10 s und 30 s bestimmt. Wenn die im Zellendatenblatt definierten Temperaturen T beispielsweise von 20 °C und 30 °C sind, können diese Referenzströme $i_{ref}$ interpoliert werden, wenn dies vom Zellendatenblatt erlaubt ist.

In einem Schritt S2 wird für jeden Referenzstrom $i_{ref}$ eine entsprechende Referenzzeitkonstante $\tau_{ref}$ anhand eines Modells zur Berechnung eines Durchschnittswerts $i_{avrg}$ eines Ladestroms $i_{req}$ mithilfe eines Dauerstroms $i_{cont}$ berechnet, der dem minimalen Strom, der ohne Lithium-Plating zulässig ist, entspricht. Beispielsweise, wenn aus dem Zellendatenblatt hervorgeht, dass ein Strom von 150 A nur 2 s dauern darf, muss dieser Strom dann für 2 s oder weniger zugelassen werden. Dazu wird der Referenzzeitkonstante $\tau_{ref}$ derart angepasst, dass der Grenzwert des Stroms bei 2 s oder früher eintrifft. Beispielsweise wird für die jeweiligen Referenzströme $i_{ref2s}$, $i_{ref10s}$ und $i_{ref30s}$ eine entsprechende Referenzzeitkonstante $\tau_{ref2s}$, $\tau_{ref10s}$ und $\tau_{ref30s}$ berechnet. Vorzugsweise wird das Modell als ein PT1-Glied ausgebildet.

In einem Schritt S3 wird anhand der berechneten Referenzzeitkonstanten $\tau_{ref}$ und der bestimmten Referenzenströme $i_{ref}$ ein Diagramm über das Verhältnis zwischen der Referenzzeitkonstante $\tau_{ref}$ und dem Referenzstrom $i_{ref}$ für jede bestimmte Temperatur T und jeden bestimmten Ladezustand SOC gebildet.

In einem Schritt S4 wird eine prädiktive Zeitkonstante $\tau_{pred}$ durch Vergleich eines Messwerts $i_{sens}$ eines Ladestroms $i_{req}$ mit den Referenzströmen $i_{ref}$ ermittelt. Wenn der Messwert $i_{sens}$ des Ladestroms $i_{req}$ gleich einem Referenzstrom $i_{ref}$ ist, ist der die prädiktive Zeitkonstante $\tau_{pred}$ gleich der diesem Referenzstrom $i_{ref}$ entsprechenden Referenzzeitkonstante $\tau_{ref}$. Andernfalls wird die prädiktive Zeitkonstante $\tau_{pred}$ durch Interpolation ermittelt.

In einem Schritt S5 wird ein prädiktiver Grenz-Durchschnittswert $i_{pred}$ des Ladestroms $i_{req}$ basierend auf dem Dauerstrom $i_{cont}$, einer prädiktiven Dauer $t_{pred}$ und der prädiktive Zeitkonstante $\tau_{pred}$ berechnet. Die prädiktive Dauer kann kundenspezifisch sein.

In einem Schritt S6 werden basierend auf dem Grenz-Durchschnittswert $i_{pred}$ ein erster prädiktiver Grenzwert $i_{predS}$ für eine kurze prädiktive Dauer $t_{predS}$, ein zweiter prädiktiver Grenzwert $i_{predL}$ für eine lange prädiktive Dauer $t_{predL}$ und ein dritter prädiktiver Grenzwert $i_{predP}$ für eine permanente prädiktive Dauer $t_{predP}$ berechnet. Beispielsweise kann eine Dauer von weniger als 2 s als eine kurze prädiktive Dauer $t_{predS}$ definiert werden. Beispielsweise kann eine lange prädiktive Dauer $t_{predL}$ gleich 2 s sein, während eine permanente prädiktive Dauer $t_{predP}$ gleich 10 s sein kann.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

**Patentansprüche**

1. Verfahren zur Steuerung eines Ladestromgrenzwerts für ein Batteriemanagementsystem, **gekennzeichnet durch** folgende Schritte:

   - Bestimmen von Referenzenströmen $i_{ref}$ für eine gemessene Temperatur $T_{sens}$ und einen gegebenen Ladezustand SOC für unterschiedliche Dauern $t_{ref}$;
   - Berechnen einer entsprechenden Referenzzeitkonstante $\tau_{ref}$ für jeden Referenzstrom $i_{ref}$ anhand eines Modells zur Berechnung eines Durchschnittswerts $i_{avrg}$ eines Ladestroms $i_{req}$ mithilfe eines Dauerstroms $i_{cont}$, der dem minimalen Strom, der ohne Lithium-Plating zulässig ist, entspricht;
   - Bilden eines Diagramms über das Verhältnis zwischen der Referenzzeitkonstante $\tau_{ref}$ und dem Referenzstrom $i_{ref}$ anhand der berechneten Referenzzeitkonstanten $\tau_{ref}$ und der bestimmten Referenzenströme $i_{ref}$ für jede bestimmte Temperatur T und jeden bestimmten Ladezustand SOC;
   - Ermitteln einer prädiktiven Zeitkonstante $\tau_{pred}$ **durch** Vergleich eines Messwerts $i_{sens}$ eines Ladestroms $i_{req}$

mit den Referenzströmen $i_{ref}$;

- Berechnen eines prädiktiven Grenz-Durchschnittswerts $i_{pred}$ des Ladestroms $i_{req}$ basierend auf dem Dauerstrom $i_{cont}$, einer prädiktiven Dauer $t_{pred}$ und der prädiktiven Zeitkonstante $\tau_{pred}$.

**2.** Verfahren nach Anspruch 1, **dadurch gekennzeichnet, dass** das Modell zur Berechnung eines Durchschnittswerts $i_{avrg}$ des Ladestroms $i_{req}$ als ein PT1-Glied ausgebildet wird.

**3.** Verfahren nach Anspruch 2, **dadurch gekennzeichnet, dass** ein zusätzlicher Punkt [$i_{min}$; $\tau_{relax}$] in das Diagramm über das Verhältnis zwischen der Referenzzeitkonstante $\tau_{ref}$ und dem Referenzstrom $i_{ref}$ hinzugefügt wird.

**4.** Verfahren nach einem der Ansprüche 1 bis 3, **dadurch gekennzeichnet, dass**
das Berechnen der dem Messwert $i_{sens}$ des Ladestroms $i_{req}$ entsprechenden prädiktiven Zeitkonstante $\tau_{pred}$ durch lineare Interpolation ausgeführt wird.

**5.** Verfahren nach einem der Ansprüche 1 bis 3, **dadurch gekennzeichnet, dass**
ein erster prädiktiver Grenzwert $i_{predS}$ für eine kurze prädiktive Dauer $t_{predS}$, ein zweiter prädiktiver Grenzwert $i_{predL}$ für eine lange prädiktive Dauer $t_{predL}$ und ein dritter prädiktiver Grenzwert $i_{predP}$ für eine permanente prädiktive Dauer $t_{predP}$ berechnet werden.

**6.** Verfahren nach Anspruch 5, **dadurch gekennzeichnet, dass** bei der Berechnung des ersten prädiktiven Grenzwert $i_{predS}$ eine Konstante $k = e^{-\frac{t_{pred}}{\tau}}$ festgelegt wird.

**7.** Batteriemanagementsystem, das dazu eingerichtet ist, ein Verfahren nach einem der Ansprüche 1 bis 6 durchzuführen.

**8.** Batterie mit einer oder mehreren Batteriezellen, die dazu eingerichtet ist, ein Verfahren nach einem der Ansprüche 1 bis 6 durchzuführen, und/oder die ein Batteriemanagementsystem nach Anspruch 7 umfasst.

**9.** Fahrzeug, das dazu eingerichtet ist, ein Verfahren nach einem der Ansprüche 1 bis 6 durchzuführen, und/oder das ein Batteriemanagementsystem nach Anspruch 7 und/oder eine Batterie nach Anspruch 8 umfasst.

**Claims**

**1.** Method for controlling a charging current limit value for a battery management system, **characterized by** the following steps:

- determining reference currents $i_{ref}$ for a measured temperature $T_{sens}$ and a given state of charge SOC for different periods $t_{ref}$;
- calculating a corresponding reference time constant $\tau_{ref}$ for each reference current $i_{ref}$ on the basis of a model for calculating an average value $i_{avrg}$ of a charging current $i_{req}$ using a continuous current $i_{cont}$ that corresponds to the minimum current permissible without lithium plating;
- forming a diagram of the relationship between the reference time constant $i_{ref}$ and the reference current $i_{ref}$ on the basis of the calculated reference time constants $\tau_{ref}$ and the determined reference currents $i_{ref}$ for each particular temperature T and each particular state of charge SOC;
- ascertaining a predictive time constant $\tau_{pred}$ by comparing a measured value $i_{sens}$ of a charging current $i_{req}$ with the reference currents $i_{ref}$;
- calculating a predictive limit average value $i_{pred}$ of the charging current $i_{req}$ based on the continuous current $i_{cont}$, a predictive period $t_{pred}$ and the predictive time constant $\tau_{pred}$.

**2.** Method according to Claim 1, **characterized in that** the model for calculating an average value $i_{avrg}$ of the charging current $i_{req}$ is in the form of a PT1 element.

**3.** Method according to Claim 2, **characterized in that** an additional point [$i_{min}$; $\tau_{relax}$] is added to the diagram of the relationship between the reference time constant $\tau_{ref}$ and the reference current $i_{ref}$.

4. Method according to one of Claims 1 to 3, **characterized in that**
the calculation of the predictive time constant $\tau_{pred}$ corresponding to the measured value $i_{sens}$ of the charging current $i_{req}$ is executed by linear interpolation.

5. Method according to one of Claims 1 to 3, **characterized in that**
a first predictive limit value $i_{predS}$ for a short predictive period $t_{predS}$, a second predictive limit value $i_{predL}$ for a long predictive period $t_{predL}$, and a third predictive limit value $i_{predP}$ for a continuous predictive period $t_{predP}$ are calculated.

6. Method according to Claim 5, **characterized in that** a constant $k = e^{-\frac{t_{pred}}{\tau}}$ is defined in the calculation of the first predictive limit value $i_{predS}$.

7. Battery management system, which is designed to carry out a method according to one of Claims 1 to 6.

8. Battery having one or more battery cells, which is designed to carry out a method according to one of Claims 1 to 6, and/or which comprises a battery management system according to Claim 7.

9. Vehicle, which is designed to carry out a method according to one of Claims 1 to 6, and/or which comprises a battery management system according to Claim 7 and/or a battery according to Claim 8.

**Revendications**

1. Procédé permettant de commander une valeur limite de courant de charge pour un système de gestion de batterie, **caractérisé par** les étapes suivantes consistant à :

   - déterminer des courants de référence $i_{ref}$ pour une température mesurée $T_{sens}$ et un état de charge SOC donné pour différentes durées $t_{ref}$ ;
   - calculer une constante de temps de référence $i_{ref}$ correspondante pour chaque courant de référence $i_{ref}$ à l'aide d'un modèle pour calculer une valeur moyenne $i_{avrg}$ d'un courant de charge $i_{req}$ à l'aide d'un courant permanent $i_{cont}$ qui correspond au courant minimal admissible sans placage au lithium ;
   - créer un diagramme concernant le rapport entre la constante de temps de référence $i_{ref}$ et le courant de référence $i_{ref}$ à l'aide de la constante de temps de référence $\tau_{ref}$ calculée et des courants de référence $i_{ref}$ déterminés pour chaque température T déterminée et chaque état de charge SOC déterminé ;
   - établir une constante de temps prédictive $\tau_{pred}$ en comparant une valeur de mesure $i_{sens}$ d'un courant de charge $i_{req}$ avec les courants de référence $i_{ref}$ ;
   - calculer une valeur moyenne limite prédictive $i_{pred}$ du courant de charge $i_{req}$ sur la base du courant permanent $i_{cont}$, d'une durée prédictive $t_{pred}$ et de la constante de temps prédictive $\tau_{pred}$.

2. Procédé selon la revendication 1, **caractérisé en ce que**
le modèle pour calculer une valeur moyenne $i_{avrg}$ du courant de charge $i_{req}$ est réalisé sous la forme d'un élément PT1.

3. Procédé selon la revendication 2, **caractérisé en ce que**
qu'un point supplémentaire [$i_{min}$; $\tau_{relax}$] est ajouté au diagramme concernant le rapport entre la constante de temps de référence $i_{ref}$ et le courant de référence $i_{ref}$.

4. Procédé selon l'une quelconque des revendications 1 à 3, **caractérisé en ce que**
le calcul de la constante de temps prédictive $\tau_{pred}$ correspondant à la valeur de mesure $i_{sens}$ du courant de charge $i_{req}$ est effectué par interpolation linéaire.

5. Procédé selon l'une quelconque des revendications 1 à 3, **caractérisé en ce que**
qu'une première valeur limite prédictive $i_{predS}$ pour une courte durée prédictive $t_{predS}$, une deuxième valeur limite prédictive $i_{predL}$ pour une longue durée prédictive $t_{predL}$ et une troisième valeur limite prédictive $i_{predP}$ pour une durée prédictive permanente $t_{predP}$ sont calculées.

6. Procédé selon la revendication 5, **caractérisé en ce que**

qu'une constante $k = e^{-\frac{t_{pred}}{\tau}}$ est définie lors du calcul de la première valeur limite prédictive $i_{predS}$.

7. Système de gestion de batterie, conçu pour exécuter un procédé selon l'une quelconque des revendications 1 à 6.

8. Batterie pourvue d'une ou de plusieurs cellules de batterie et qui est conçue pour exécuter un procédé selon l'une quelconque des revendications 1 à 6, et/ou qui comprend un système de gestion de batterie selon la revendication 7.

9. Véhicule, conçu pour exécuter un procédé selon l'une quelconque des revendications 1 à 6, et/ou qui comprend un système de gestion de batterie selon la revendication 7 et/ou une batterie selon la revendication 8.

**FIG. 1**

EP 4 138 258 B1

FIG. 2

FIG. 3.1

FIG. 3.2

FIG. 3.3

FIG. 4.1

FIG. 4.2

FIG. 4.3

FIG. 5.1

FIG. 5.2

FIG. 5.3

FIG. 6.1

FIG. 6.2

FIG. 6.3

EP 4 138 258 B1

**FIG. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 9035621 B2